(19)

**Europäisches Patentamt**
**European Patent Office**
**Office européen des brevets**

(11) **EP 1 601 072 B1**

(12) **EUROPÄISCHE PATENTSCHRIFT**

(45) Veröffentlichungstag und Bekanntmachung des Hinweises auf die Patenterteilung:
**30.05.2007 Patentblatt 2007/22**

(51) Int Cl.:
*H01S 5/40* *(2006.01)*     *G02B 27/12* *(2006.01)*
*G02B 27/09* *(2006.01)*     *H01S 5/00* *(2006.01)*

(21) Anmeldenummer: **04012863.9**

(22) Anmeldetag: **29.05.2004**

(54) **Strahlformungsoptik und -modul für eine Diodenlaseranordnung**

Beam shaping optics and module for a diode laser assembly

Système et module de mise en forme des faisceaux optiques pour montage des lasers à diodes

(84) Benannte Vertragsstaaten:
**AT CH DE FR GB IT LI**

(43) Veröffentlichungstag der Anmeldung:
**30.11.2005 Patentblatt 2005/48**

(73) Patentinhaber: **TRUMPF Laser GmbH + Co. KG**
**78713 Schramberg (DE)**

(72) Erfinder:
 • **Voss, Andreas**
  **78713 Schramberg (DE)**
 • **Huonker, Martin**
  **78658 Zimmern (DE)**
 • **Liemann, Martin**
  **78052 Villingen Schwenningen (DE)**
 • **Wallmeroth, Klaus**
  **78658 Zimmern (DE)**
 • **Kumkar, Malte**
  **78713 Schramberg (DE)**
 • **Dorsch, Friedhelm**
  **78658 Zimmern o.R. (DE)**
 • **Schmitz, Christian**
  **78655 Dunningen (DE)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 1 081 819**     **DE-A- 10 204 796**
**DE-A- 19 918 444**     **US-A- 5 900 981**
**US-B1- 6 377 410**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft eine Strahlformungsoptik für eine Diodenlaseranordnung.

Als Pumplichtquelle für diodengepumpte Hochleistungsfestkörperlaser dienen z.B. aktiv mit Mikrokanalwärmesenken gekühlte Diodenlaseranordnungen mit vertikalen Laserdiodenstapeln (vertikalen Stacks) aus Laserdiodenbarren. Diese Stacks weisen bei einer ausreichend großen Stapelhöhe (ca. 50 Laserdiodenbarren) ein in etwa gleich großes Strahlparameterprodukt in horizontaler Richtung (Slow-Axis, SA) und in vertikaler Richtung (Fast-Axis, FA) auf. Dies ermöglicht eine einfache Einkopplung der von diesen vertikalen Stacks ausgehenden Strahlung in einen (nahezu) rotationssymmetrischen Lichtmischer unter annähernder Beibehaltung der Brillanz der Pumpstrahlung. Im Lichtmischer wird die Pumpstrahlung durch Mehrfachreflexion homogenisiert. Die aus dem Lichtmischer austretende Strahlung eignet sich zur Abbildung eines runden Pumpflecks auf einen Laserkristall. Nachteilig ist die begrenzte Lebenserwartung der aktiv gekühlten, vertikalen Stacks von ca. 10000 h.

Aus der DE 100 61 265 A1 sind quasi-passiv gekühlte Diodenlaseranordnungen mit horizontalen Laserdiodenstapeln (2D-Passiv-Stack, horizontaler Stack) als Pumplichtquelle für Hochleistungsfestkörperlaser bekannt. Bei diesen Diodenlaseranordnungen sind die einzelnen Diodenbarren nicht in FA-Richtung übereinander, sondern in SA-Richtung nebeneinander und - in einer besonders vorteilhaften Anordnung - in FA-Richtung leicht stufig zueinander versetzt, angeordnet. Die horizontalen Stacks weisen durch die Trennung der elektrischen Funktion von der Kühlung sowie aufgrund der größeren Kühlstruktur.n und der stark reduzierten Zahl an Dichtungselementen eine wesentlich erhöhte Zuverlässigkeit gegenüber den vertikalen Stacks auf.

Nachteilig ist das optische Format, das sich durch in SA-Richtung nebeneinander aufgereihte Laserdiodenbarren ergibt. Im Gegensatz zum vertikalen Stack wird beim horizontalen Stack die Asymmetrie der Strahlqualität durch die nebeneinander angeordneten Barren und die daraus resultierende Verbreiterung des Gesamtquerschnitts der emittierten Strahlung entlang der SA-Richtung noch weiter erhöht. Außerdem sind aufgrund der vergleichsweise großen Bauhöhe der horizontalen Stacks in FA-Richtung für eine optisch bündige Stapelung in FA-Richtung FA-Kollimatorlinsen mit ungewöhnlich großer Brennweite erforderlich. Die geringe Divergenz der so kollimierten Strahlen erfordert eine sehr hohe Genauigkeit der optischen Komponenten im weiteren Strahlengang. Weiterhin ergibt sich eine für praktische Anwendungen zu große Gesamthöhe bei der für symmetrische Strahlqualität erforderlichen Anzahl gestapelter horizontaler Stacks. Daher ist zur Erzielung einer annähernden Symmetrie der Ausganggstrahlung von horizontalen Stacks eine Strahlformungsoptik notwendig.

Aus der DE 199 39 750 A1 ist eine Strahlformungsoptik zur Zusammenführung von drei Laserstrahlen, die von drei in einer gemeinsamen horizontalen Ebene liegenden Diodenbarren geliefert werden, zu einem überlagerten Laserstrahl bekannt. Mit dieser optischen Anordnung wird eine Reduktion der Ausdehnung der Laserstrahlung in SA-Richtung erreicht. Im Strahlweg unmittelbar nach den Diodenbarren befindet sich eine Korrekturoptik zur Strahlkollimation sowohl in FA-Richtung als auch in SA-Richtung. Die optische Anordnung weist Lateralversetzungselemente zur Lateralversetzung (Parallelverschiebung) der beiden äußeren Laserstrahlen entlang der SA-Richtung auf, die aus einem Strahlumlenkelement und einem Kopplungselement (Prismenwürfel) bestehen.

Die DE 199 39 750 A1 offenbart weiterhin eine Strahlformungsoptik zur Zusammenführung von zwei Laserstrahlen, die von in SA-Richtung nebeneinander angeordneten, in FA-Richtung leicht stufig zueinander versetzten Diodenbarren geliefert werden, zu einem verkämmten Laserstrahl. Diese optische Anordnung umfasst zwei in FA-Richtung übereinander und in SA-Richtung im Winkel zur einlaufenden Strahlung angeordnete Planparallelplatten, die in Transmission durchlaufen werden. Durch die Lichtbrechung an den im Winkel zur Strahlausbreitungsrichtung angeordneten Ein- und Austrittsflächen werden die zwei einlaufenden Laserstrahlen lateral in der SA-Richtung jeweils um den halben Mittenabstand der Strahlen versetzt, wodurch sie kammartig übereinander geschoben werden (sog. interleaving):

Demgegenüber ist es die Aufgabe der vorliegenden Erfindung, eine Strahlformungsoptik bereitzustellen, die die aus einem horizontalen Diodenlaserstack mit mehreren stufig zueinander versetzten Diodenbarren emittierten Laserstrahlen so zusammenführt, dass eine Einkopplung in einen annähernd rotationssymmetrischen Lichtmischer ermöglicht wird.

Diese Aufgabe wird erfindungsgemäß gelöst durch eine Strahlformungsoptik mit mindestens einer Verkämmungsstufe zur Zusammenführung von drei in zwei Richtungen zueinander lateral versetzten, einlaufenden Laserstrahlen zu einem auslaufenden verkämmten Laserstrahl, wobei die Verkämmungsstufe zwei Lateralversetzungseinheiten zum Lateralversetzen jeweils eines der beiden in der ersten Richtung äußeren einlaufenden Laserstrahlen entlang der ersten Richtung hin zum mittleren einlaufenden Laserstrahl aufweist, welcher die Verkämmungsstufe lateral unversetzt durchläuft, und wobei die Lateralversetzungseinheiten jeweils mindestens ein Lateralversetzungselement mit höherer Brechzahl als das Medium aufweisen, welches sich im Strahlengang des mittleren Laserstrahls in der Verkämmungsstufe befindet, wobei die von den äußeren Laserstrahlen in den Lateralversetzungselementen zurückgelegte Weglänge derart gewählt ist, dass am Ende der Verkämmungsstufe die Durchmesser der Laserstrahlen zumindest in der ersten Richtung annähernd gleich sind und der auslaufende, verkämmte Laserstrahl über seinen Strahlquerschnitt ein im Wesentlichen identisches Divergenzverhalten aufweist.

Die einlaufenden Laserstrahlen können z.B. von einem aus der DE 100 61 265 A1 bekannten horizontalen Stack geliefert werden, wobei jeweils ein Laserstrahl von einem Diodenbarren emittiert wird und die Diodenbarren in der ersten, horizontalen Richtung (SA) nebeneinander angeordnet sind und wobei die Diodenbarren in vertikaler Richtung leicht stufig zueinander versetzt sind. Da typischerweise mehr als drei Diodenbarren nebeneinander auf einem horizontalen Stack angeordnet sind, kann es günstig sein, mehrere Verkämmungseinrichtungen nebeneinander oder hintereinander im Strahlweg der Laserstrahlen anzuordnen.

Im Gegensatz zum Stand der Technik können mittels der erfindungsgemäßen Strahlformungsoptik drei einlaufende Laserstrahlen verkämmt werden, wozu nur zwei Lateralversetzungseinheiten benötigt werden. Die geometrische Weglänge der beiden äußeren Laserstrahlen durch die Verkämmungsstufe ist aufgrund des Lateralversatzes größer als die geometrische Weglänge, die der mittlere Laserstrahl in der Verkämmungsstufe zurücklegt. Laserstrahlen, die eine Strahldivergenz aufweisen, weiten sich in Abhängigkeit von der zurückgelegten geometrischen Weglänge auf. Der Durchmesser der drei Laserstrahlen am Ende der Verkämmungsstufe wird durch geeignete Auslegung der Brechzahl der Lateralversetzungselemente und der Weglänge der äußeren Laserstrahlen durch die Lateralversetzungselemente hindurch annähernd gleich groß gemacht, sodass sichergestellt ist, dass der auslaufende, verkämmte Laserstrahl über seinen Strahlquerschnitt ein im Wesentlichen identisches Divergenzverhalten aufweist. Auf diese Weise sind die Bildebenen der drei Diodenbarren, von denen die drei Laserstrahlen ausgehen, nach der Verkämmungsstufe in Strahlrichtung annähernd deckungsgleich. So können die verkämmten Strahlen durch weitere optische Elemente (beispielsweise Linsen oder Linsenteleskope) in einen Lichtmischer oder auch direkt auf ein Festkörperlasermedium fokussiert werden.

Die Strahlaufweitung innerhalb eines optischen Mediums ist in einem höherbrechenden Medium geringer als in einem niedrigerbrechenden Medium, was sich daraus ergibt, dass die Lichtstrahlen durch den Übergang in das höherbrechende Medium zur optischen Achse hin gebrochen werden und daher im optischen Medium mit geringerer Divergenz verlaufen.

Dieser Effekt wird bei der Angleichung der Durchmesser der Laserstrahlen am Ende der Verkämmungsstufe dahingehend ausgenutzt, dass der längere geometrische Weg durch die Lateralversetzungseinheiten hindurch durch einen höheren Brechungsindex der optischen Medien in diesen Einheiten ausgeglichen wird. Daher weisen die Lateralversetzungseinheiten jeweils ein Lateralversetzungselement mit höherer Brechzahl als das Medium auf, welches sich im Strahlengang des mittleren Laserstrahls in der Verkämmungsstufe befindet.

Bei einer vorteilhaften Ausführungsform der Strahlformungsoptik sind die einlaufenden Laserstrahlen und der auslaufende Laserstrahl parallel zueinander, was eine kompakte Bauweise der Strahlformungsoptik ermöglicht und die Justierempfindlichkeit minimiert.

Der mittlere Strahl durchläuft die Strahlformungsoptik vorzugsweise vollständig in Luft, sodass er ohne Beeinflussung durch ein optisches Element durch die Strahlformungsoptik hindurchtritt. Dies minimiert die Kosten und die Justierempfindlichkeit der Strahlformungsoptik und die Verluste an Strahlungsintensität.

Besonders vorteilhaft ist weiterhin eine Ausführungsform, bei der die Lateralversetzungseinheiten den Lateralversatz durch Totalreflexion an mindestens zwei Totalreflexionsflächen erzeugen. Bei der Strahlumlenkung mittels Totalreflexion tritt nur geringer Lichtverlust auf und Totalreflexionsflächen müssen nicht entspiegelt werden.

Bei einer bevorzugten Weiterbildung dieser Ausführungsform sind die Lateralversetzungseinheiten als Doppelumlenkprismen ausgebildet. Die Totalreflexion an zwei Seitenflächen von Doppelumlenkprismen stellt eine besonders einfache Möglichkeit dar, mit einem einzigen optischen Element einen Lateralversatz zu erzeugen. Durch die Vereinigung der beiden Reflexionsflächen in einem Bauelement werden der Justageaufwand und die Dejustagegefahr minimiert.

Bei einer weiteren besonders vorteilhaften Ausführungsform der Strahlformungsoptik ist vor der Verkämmungsstufe eine weitere Verkämmungsstufe angeordnet, die zwei in der ersten und zweiten Richtung zueinander lateral versetzte, einlaufende Laserstrahlen zu einem verkämmten auslaufenden Laserstrahl zusammenführt. Die vorgeordnete Verkämmungsstufe kann zwei Lateralversetzungseinheiten, insbesondere Planparallelplatten, zum Lateralversetzen der zwei einlaufenden Laserstrahlen entlang der ersten Richtung aufeinander zu umfassen. Durch die Verwendung zweier Verkämmungsstufen lässt sich die Verkämmung optimieren. Planplatten sind kostengünstig herstellbare optische Elemente, mit denen sich auf einfache Weise eine Lateralversetzung erreichen lässt. Vorzugsweise tritt der einlaufende Laserstrahl in eine Eintrittsfläche der Lateralversetzungseinheit unter dem Brewster-Winkel ein, wodurch auch ohne reflexionsmindernde Beschichtungen unerwünschte Reflexionen an der Eintrittsfläche (und an der Austrittsfläche) vermieden werden.

Die Erfindung betrifft in einem weiteren Aspekt auch ein Strahlformungsmodul mit mindestens zwei Strahlformungsoptiken der oben beschriebenen Art, welche entlang der zweiten Richtung zu mindestens einer Stapeleinheit zusammengefügt sind. Vorzugsweise sind die einzelnen Strahlformungsoptiken identisch. Das Strahlformungsmodul kann vorteilhaft zur Zusammenführung von Laserstrahlen verwendet werden, die von zwei oder mehr entlang der zweiten, vertikalen Richtung (FA) übereinander gestapelten horizontalen Stacks geliefert werden.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1 eine Draufsicht auf eine Ausführungsform der erfindungsgemäßen Strahlformungsoptik für eine Diodenlaseranordnung;

Fig. 2 eine Seitenansicht der in Fig. 1 gezeigten Strahlformungsoptik;

Fig. 3 eine Seitenansicht eines Strahlformungsmoduls mit zwei Strahlformungsoptiken der Fig. 1; und

Fig. 4 eine Darstellung zur Verdeutlichung der verminderten Divergenz eines Laserstrahls beim Durchtritt durch eine Planplatte.

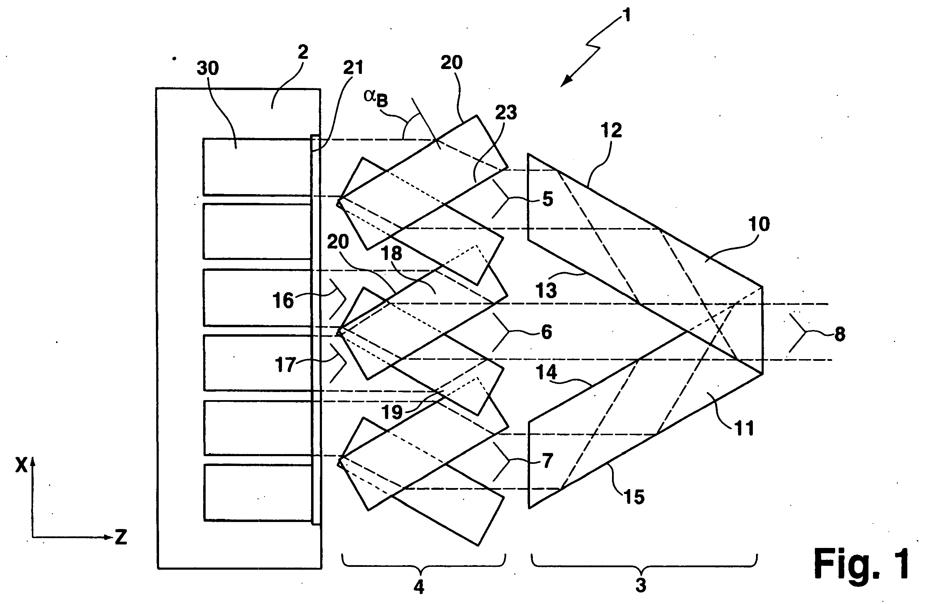

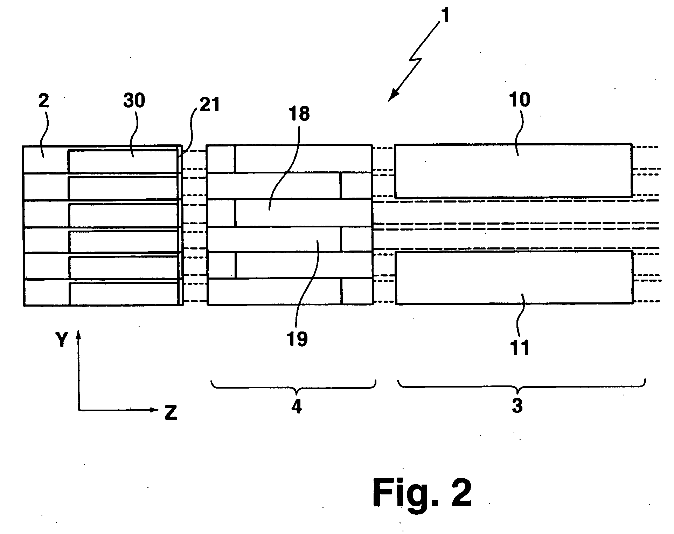

Die in **Fig. 1** in einer Draufsicht sowie in **Fig. 2** in einer Seitenansicht gezeigte Strahlformungsoptik **1** dient zur Zusammenführung (Verkämmung) von sechs Laserstrahlen, die von einer Diodenlaseranordnung **2**, welche als horizontaler Stack mit sechs Diodenbarren **30** ausgebildet ist, parallel zueinander in Z-Richtung emittiert werden und von denen vier in Fig. 1 durch ihre Randstrahlen dargestellt sind.

Um die weitere Strahlformungsoptik möglichst einfach gestalten zu können, sind die Diodenbarren **30** mit einem geringen vertikalen Versatz angeordnet (sog. "Barren-Pitch"). Dieser Pitch beträgt typischerweise ca. 1,5 mm, was der ca. 1,5- bis 2-fachen Ausdehnung eines Laserstrahls **16, 17** in Y-Richtung (FA-Richtung) entspricht, nachdem dieser einen FA-Kollimator **21** durchlaufen hat, welcher unmittelbar an die Diodenbarren **30** anschließt. Zur Erzeugung dieses Versatzes werden vorzugsweise die Wärmesenken der Diodenbarren **30** leicht keilförmig in X-Richtung (SA-Richtung) ausgeführt, was die Verwendung identischer Wärmesenken für alle Diodenbarren **30** erlaubt. In Strahlrichtung (Z-Richtung) betrachtet ist die Strahlung der Diodenbarren **30** in Form einer flachen Treppe angeordnet. Relativ zur horizontal ausgerichteten SA-Richtung ist eine nicht bildlich dargestellte Kühlplatte des horizontalen Stacks **2** leicht gekippt.

Die Strahlformungsoptik **1** zur Zusammenführung der Laserstrahlung der Diodenbarren **30** weist zwei im Strahlweg hintereinander angeordnete Verkämmungsstufen **3, 4** auf. In der ersten Verkämmungsstufe **4** werden die von jeweils zwei benachbarten Diodenbarren **30** des horizontalen Stacks **2** emittierten Laserstrahlen **16, 17** jeweils mittels zweier Lateralversetzungseinheiten **18, 19,** welche durch zwei unter entgegengesetzt gleichen Winkeln zur Strahlrichtung angeordnete Planparallelplatten gebildet sind, paarweise symmetrisch übereinandergelegt. Aufgrund der Symmetrie der Anordnung ist die optische Weglänge für die Laserstrahlen aus den Diodenbarren **30** in der ersten Verkämmungsstufe **4** gleich. Zur Erzeugung des horizontalen Strahlversatzes werden die Planparallelplatten **18, 19** in Transmission durchlaufen. Hierbei bildet die Flächennormale einer Eintrittsfläche **20** der Planparallelplatten mit den Laserstrahlen **16, 17** einen Winkel, der dem Brewster-Winkel $\alpha_B$ des Materials der Planparallelplatten **18, 19** entspricht. Durch Nutzung des Brewster-Winkels $\alpha_B$ kann, da die Diodenbarren **30** horizontal polarisiert emittieren, auf eine Entspiegelung der Ein- und Austrittsflächen der Planparallelplatten **18, 19** verzichtet werden. Für eine Planparallelplatte **18, 19** werden lediglich zwei optische Flächen, nämlich die Eintrittsfläche **20** und eine Austrittsfläche **23,** mit guter Parallelität benötigt. Die Justierempfindlichkeit der Planparallelplatten **18, 19** ist gering. Die Richtung der austretenden Strahlung wird weder durch Verdrehen noch durch Verschieben der Planparallelplatten **18, 19** beeinflußt.

In der zweiten Verkämmungsstufe **3** der Strahlformungsoptik **1** werden die nach der ersten Verkämmungsstufe **4** horizontal versetzt angeordneten, einlaufenden Laserstrahlen **5, 6, 7** vollständig übereinandergelegt, so dass ein auslaufender Laserstrahl **8** als vertikaler optischer Laserstrahlenstapel die Strahlformungsoptik **1** verlässt. Die zweite Verkämmungsstufe **3** weist zwei Lateralversetzungseinheiten **10, 11** in Form von Doppelumlenkprismen auf, die mit senkrecht zur Strahlausbreitungsrichtung angeordneten Ein- und Austrittsflächen und parallelen, schräg angeordneten Seitenflächen **12, 13, 14, 15** zur paarweisen Totalreflexion und damit zur Erzielung eines horizontalen Strahlversatzes positioniert sind. Die vertikale Ausdehnung der Doppelumlenkprismen **10, 11** beträgt das Zweifache des Barren-Pitchs. In der Verkämmungsstufe **3** kann auf eine vollständige Symmetrie verzichtet werden, da die effektiven Weglängen der drei einlaufenden Laserstrahlen **5, 6, 7** nahezu gleich lang sind. Die optische Verkürzung durch Propagation der zwei äußeren Laserstrahlen **5, 7** im höherbrechenden Medium der Doppelumlenkprismen **10, 11** wird hierbei genutzt, um die größere geometrische Weglänge der beiden horizontal versetzten Laserstrahlen **5, 7** gegenüber dem mittleren Laserstrahl **6** zu kompensieren. Im vorliegenden Fall werden nur zwei identische Doppelumlenkprismen **10, 11** für die Zusammenführung der Laserstrahlung des horizontalen Stacks **2** benötigt. Der mittlere Laserstrahl **6** geht, ohne ein optisches Element zu durchlaufen, zwischen den beiden Doppelumlenkprismen **10, 11** hindurch.

Bezüglich der mechanischen Fixierung der optischen Elemente der ersten Verkämmungsstufe **4** und der zweiten Verkämmungsstufe **3** bestehen verschiedene Möglichkeiten. Die Planparallelplatten **18, 19** der ersten Verkämmungsstufe **4** können beispielsweise am horizontalen Stack **2** befestigt werden. Hierzu müssen die Kühlplatten und/oder die Wärmesenken des horizontalen Stacks **2** ausreichend weit unter den Planparallelplatten **18, 19** ausgedehnt sein und vorzugsweise eine plane, SA-parallele Auflagefläche umfassen, auf die die Planparallelplatten **18, 19** aufgeklebt werden können. Anschließend an die Verkämmung wird der auslaufende Laserstrahl **8** in der FA-Richtung mit Hilfe einer nicht dargestellten Zylinderlinse auf die Eintrittsfläche eines nicht dargestellten Lichtmischers fokussiert und in der SA-Richtung mit Hilfe eines Zylinderlinsenteleskops auf diese Eintrittsfläche abgebildet.

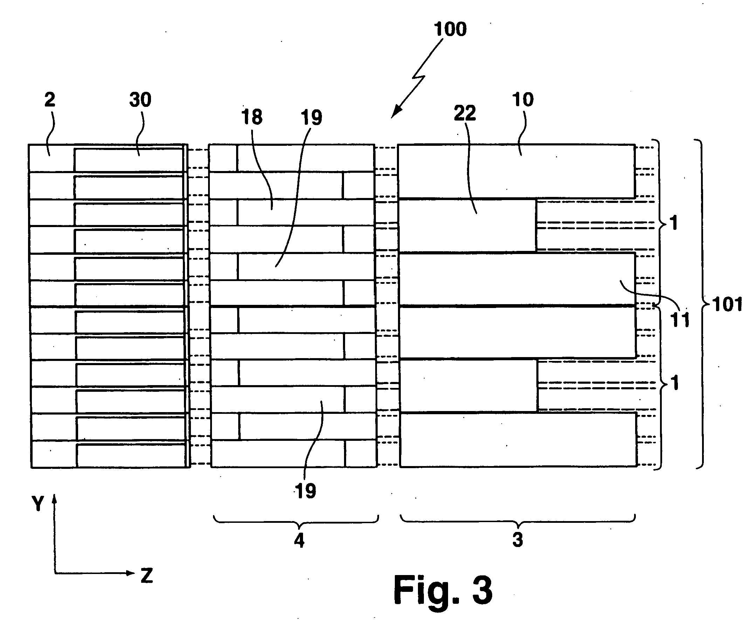

In **Fig. 3** ist eine Seitenansicht eines Strahlformungsmoduls **100** mit zwei der in Fig. 1 gezeigten Strahlformungsoptiken **1** gezeigt, welche identisch aufgebaut und in Y-Richtung zu einer Stapeleinheit **101** übereinander gestapelt sind. Durch diese Aufteilung der benötigten Anzahl der Diodenbarren **30** auf mehrere, vertikal gestapelte horizontale Stacks **2** lässt sich ein sehr kompaktes Format einer Pumplichtquelle für Hochleistungsfestkörperlaser erreichen. Die Doppelumlenkprismen **10, 11** der zweiten Verkämmungsstufe **3** können hierbei beispielsweise mit Hilfe von zusätzlichen - außerhalb des Strahlenganges befindlichen - Abstandshaltern **22** - vorzugsweise aus Glas - zu einem quasimonolithischen Stapel zusammengefügt (z.B. geklebt) werden.

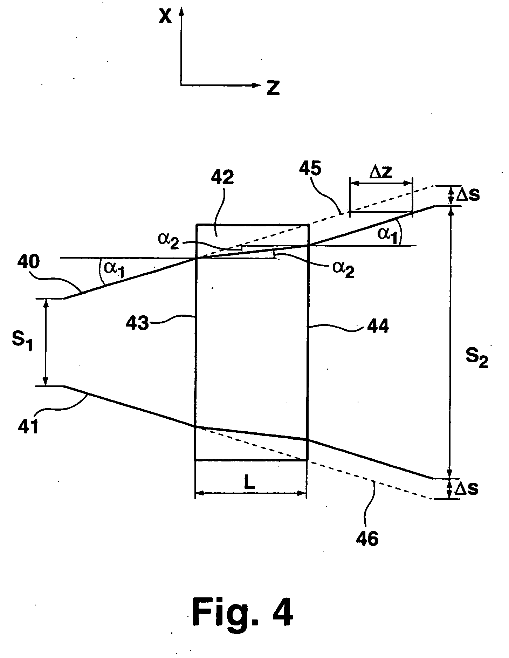

In **Fig. 4** ist die Verringerung der Divergenz eines Laserstrahls beim Durchtriltt durch eine Planplatte **42** veranschaulicht, welche eine höhere Brechzahl als das umgebende Medium (z.B. Luft) aufweist. Der Laserstrahl weist vor dem Eintritt in die Planplatte **42** einen Durchmesser $S_1$ in X-Richtung auf. Er ist durch zwei Randstrahlen **40, 41** veranschaulicht, welche unter einem Winkel $\alpha_1$ bezüglich des Einfallslots (Z-Richtung) auf eine Eintrittsfläche **43** der Planplatte **42** auftreffen. Beim Durchtritt durch die Eintrittsfläche werden die Randstrahlen **40, 41** zum Einfallslot hin gebrochen, sodass sie im Inneren der Planplatte **42** unter einem Winkel $\alpha_2$ bezüglich des Lots verlaufen. Der Öffnungswinkel des Laserstrahls und somit die Strahldivergenz ist daher innerhalb der Planplatte **42** mit größerer Brechzahl somit geringer als im umgebenden Medium mit geringerer Brechzahl. Beim Durchtritt der Ranstrahlen **40, 41** durch eine Austrittsfläche **44** der Planplatte **42** werden diese so gebrochen, dass sie hinter der Planplatte **42** wieder unter dem Winkel $\alpha_1$ bezüglich der Z-Richtung verlaufen. Die Strahldivergenz vor dem Eintritt des Laserstrahls in die Planplatte **42** und nach dem Austritt des Laserstrahls aus der Planplatte **42** sind somit identisch. Der Durchmesser $S_2$ des Laserstrahls nach dem Austritt aus der Planplatte **42** ist in X-Richtung jedoch um $2\Delta s$ geringer als der eines Laserstrahls, der sich ausschließlich im Medium mit der geringeren Brechzahl fortbewegt. Die Randstrahlen **45, 46** eines solchen Laserstrahls sind in Fig. 4 gestrichelt gezeichnet. Durch die Verwendung der Planplatte **42** lässt sich der Durchmesser des Laserstrahls in X-Richtung somit um $2\Delta s$ verkürzen. Der axiale Versatz $\Delta z$ (in Strahlrichtung Z) des durch die Planplatte **42** (mit Länge L in Strahlrichtung Z) verlaufenden Laserstrahls gegenüber einem ohne Durchtritt durch die Planplatte **42** in Luft verlaufenden Strahl lässt sich (bei kleinen Winkeln $\alpha_1$ und $\alpha_2$) annähernd wie folgt berechnen:

$$\Delta z \approx L * (1 - \alpha_1/\alpha_2) = L * (1 - n_1/n_2).$$

## Patentansprüche

1. Strahlformungsoptik (1) mit mindestens einer Verkämmungsstufe (3) zur Zusammenführung von drei in zwei Richtungen (X, Y) zueinander lateral versetzten, einlaufenden Laserstrahlen (5, 6, 7) zu einem auslaufenden verkämmten Laserstrahl (8), wobei die Verkämmungsstufe (3) zwei Lateralversetzungseinheiten (10, 11) zum Lateralversetzen jeweils eines der beiden in der ersten Richtung (X) äußeren einlaufenden Laserstrahlen (5, 7) entlang der ersten Richtung (X) hin zum mittleren einlaufenden Laserstrahl (6) aufweist, welcher die Verkämmungsstufe (3) lateral unversetzt durchläuft, und wobei die Lateralversetzungseinheiten (10, 11) jeweils mindestens ein Lateralversetzungselement mit höherer Brechzahl als das Medium aufweisen, welches sich im Strahlengang des mittleren Laserstrahls (6) in der Verkämmungsstufe (3) befindet, wobei die von den äußeren Laserstrahlen (5, 7) in den Lateralversetzungselementen zurückgelegte Weglänge derart gewählt ist, dass am Ende der Verkämmungsstufe (3) die Durchmesser der Laserstrahlen (5, 6, 7) zumindest in der ersten Richtung (X) annähernd gleich sind und der verkämmte Laserstrahl (8) über seinen Strahlquerschnitt ein im Wesentlichen identisches Divergenzverhalten zeigt.

2. Strahlformungsoptik nach Anspruch 1, **dadurch gekennzeichnet, dass** die einlaufenden Laserstrahlen (5, 6, 7) und der auslaufende Laserstrahl (8) parallel zueinander sind.

3. Strahlformungsoptik nach Anspruch 1 oder 2, **dadurch gekennzeichnet, dass** der mittlere Laserstrahl (6) in Luft verläuft.

4. Strahlformungsoptik nach einem der vorhergehenden Ansprüche, **dadurch gekennzeichnet, dass** die Lateralversetzungseinheiten (10, 11) den Lateralversatz jeweils durch Totalreflexion an mindestens zwei Totalreflexionsflächen (12, 13, 14, 15) erzeugen.

5. Strahlformungsoptik nach Anspruch 4, **dadurch gekennzeichnet, dass** die Lateralversetzungseinheiten (10, 11) als Doppelumlenkprismen ausgebildet sind.

**6.** Strahlformungsoptik nach einem der vorhergehenden Ansprüche, **dadurch gekennzeichnet, dass** vor der Verkämmungsstufe (3) eine weitere Verkämmungsstufe (4) angeordnet ist, die zwei in der ersten und zweiten Richtung (X, Y) zueinander lateral versetzte, einlaufende Laserstrahlen (16, 17) zu einem verkämmten auslaufenden Laserstrahl (6) zusammenführt.

**7.** Strahlformungsoptik nach Anspruch 6, **dadurch gekennzeichnet, dass** die vorgeordnete Verkämmungsstufe (4) jeweils zwei Lateralversetzungseinheiten (18, 19), insbesondere Planparallelplatten, zum Lateralversetzen der zwei einlaufenden Laserstrahlen (16, 17) entlang der ersten Richtung (X) aufeinander zu umfasst.

**8.** Strahlformungsoptik nach Anspruch 7, **dadurch gekennzeichnet, dass** der einlaufende Laserstrahl (16, 17) in eine Eintrittsfläche (20) der Lateralversetzungseinheit (18, 19) unter dem Brewster-Winkel ($\alpha_B$) eintritt.

**9.** Strahlformungsmodul (100) mit mindestens zwei Strahlformungsoptiken (1) nach einem der vorhergehenden Ansprüche, die entlang der zweiten Richtung (Y) zu mindestens einer Stapeleinheit (101) zusammengefügt sind.

**10.** Strahlformungsmodul nach Anspruch 9, **dadurch gekennzeichnet, dass** die Strahlformungsoptiken (1) identisch sind.

**Claims**

**1.** Beam-shaping optical unit (1) having at least one combing stage (3) for combining three incoming laser beams (5, 6, 7), which are laterally displaced relative to each other in two directions (X, Y), in order to form an outgoing combed laser beam (8), the combing stage (3) having two lateral displacement units (10, 11) each for laterally displacing one of the two incoming laser beams (5, 7) that are outermost in the first direction (X) in the first direction (X) relative to the central incoming laser beam (6) which travels through the combing stage (3) in a laterally non-displaced manner, and the lateral displacement units (10, 11) each having at least one lateral displacement element having a higher refractive index than the medium which is located in the beam path of the central laser beam (6) in the combing stage (3), the path length travelled by the outermost laser beams (5, 7) in the lateral displacement elements being selected in such a manner that the diameters of the laser beams (5, 6, 7) are approximately identical at least in the first direction (X) at the end of the combing stage (3) and the combed laser beam (8) has substantially identical divergence characteristics over the beam cross-section thereof.

**2.** Beam-shaping optical unit according to claim 1, **characterised in that** the incoming laser beams (5, 6, 7) and the outgoing laser beam (8) are parallel with each other.

**3.** Beam-shaping optical unit according to claim 1 or 2, **characterised in that** the central laser beam (6) extends in air.

**4.** Beam-shaping optical unit according to any one of the preceding claims, **characterised in that** the lateral displacement units (10, 11) each produce the lateral displacement by total reflection at least at two total reflection faces (12, 13, 14, 15).

**5.** Beam-shaping optical unit according to claim 4, **characterised in that** the lateral displacement units (10, 11) are in the form of double redirection prisms.

**6.** Beam-shaping optical unit according to any one of the preceding claims, **characterised in that** there is arranged upstream of the combing stage (3) an additional combing stage (4) which combines two incoming laser beams (16, 17), which are laterally displaced relative to each other in the first and second direction (X, Y), in order to form a combed outgoing laser beam (6).

**7.** Beam-shaping optical unit according to claim 6, **characterised in that** the upstream combing stage (4) comprises two lateral displacement units (18, 19), in particular plane-parallel plates, in order to laterally displace the two incoming laser beams (16, 17) towards each other in the first direction (X).

**8.** Beam-shaping optical unit according to claim 7, **characterised in that** the incoming laser beam (16, 17) is introduced into an inlet face (20) of the lateral displacement unit (18, 19) at the Brewster angle ($\alpha_B$).

**9.** Beam-shaping module (100) having at least two beam-shaping optical units (1) according to any one of the preceding claims, which are combined in the second direction (Y) in order to form at least one stack unit (101).

**10.** Beam-shaping module according to claim 9, **characterised in that** the beam-shaping optical units (1) are identical.

**Revendications**

**1.** Optique de mise en forme de faisceau (1) comprenant au moins un étage d'entrelacement (3) pour la réunion de trois faisceaux laser entrants (5, 6, 7) décalés latéralement les uns par rapport aux autres dans deux directions (X, Y) en un faisceau laser sortant entrelacé (8), l'étage d'entrelacement (3) présentant deux unités de décalage latéral (10, 11) pour le décalage latéral respectif d'un des deux faisceaux laser entrants extérieurs (5, 7) dans la première direction (X) le long de la première direction (X) vers le faisceau laser entrant central (6), lequel traverse l'étage d'entrelacement (3) sans être décalé latéralement, et les unités de décalage latéral (10, 11) présentant chacune au moins un élément de décalage latéral ayant un indice de réfraction supérieur à celui du milieu qui se trouve dans le trajet des rayons du faisceau laser central (6) dans l'étage d'entrelacement (3), la longueur de parcours effectuée par les faisceaux laser extérieurs (5, 7) dans les éléments de décalage latéral étant choisie de telle manière qu'à l'extrémité de l'étage d'entrelacement (3) le diamètre des faisceaux laser (5, 6, 7) soit à peu près égal au moins dans la première direction (X) et que le faisceau laser entrelacé (8) présente un comportement de divergence essentiellement identique sur sa section de faisceau.

2. Optique de mise en forme de faisceau selon la revendication 1, **caractérisée par le fait que** les faisceaux laser entrants (5, 6, 7) et le faisceau laser sortant (8) sont parallèles entre eux.

3. Optique de mise en forme de faisceau selon la revendication 1 ou 2, **caractérisée par le fait que** le faisceau laser central (6) se propage dans l'air.

4. Optique de mise en forme de faisceau selon l'une des revendications précédentes, **caractérisée par le fait que** les unités de décalage latéral (10, 11) produisent le décalage latéral chacune par réflexion totale sur au moins deux surfaces de réflexion totale (12, 13, 14, 15).

5. Optique de mise en forme de faisceau selon la revendication 4, **caractérisée par le fait que** les unités de décalage latéral (10, 11) sont réalisées sous la forme de doubles prismes déviateurs.

6. Optique de mise en forme de faisceau selon l'une des revendications précédentes, **caractérisée par le fait qu'**avant l'étage d'entrelacement (3) se trouve un autre étage d'entrelacement (4) qui réunit deux faisceaux laser entrants (16, 17) décalés latéralement l'un par rapport à l'autre dans la première et la deuxième direction (X, Y) en un faisceau laser sortant entrelacé (6).

7. Optique de mise en forme de faisceau selon la revendication 6, **caractérisée par le fait que** l'étage d'entrelacement (4) placé en amont comprend chaque fois deux unités de décalage latéral (18, 19), en particulier des lames à faces parallèles, pour le décalage latéral des deux faisceaux laser entrants (16, 17) l'un vers l'autre le long de la première direction (X).

8. Optique de mise en forme de faisceau selon la revendication 7, **caractérisée par le fait que** le faisceau laser entrant (16, 17) arrive sur une surface d'entrée (20) de l'unité de décalage latéral (18, 19) sous un angle de Brewster ($\alpha_B$).

9. Module de mise en forme de faisceau (100) comprenant au moins deux optiques de mise en forme de faisceau (1), selon l'une des revendications précédentes, qui sont réunies en au moins une unité d'empilage (101) le long de la deuxième direction (Y).

10. Module de mise en forme de faisceau selon la revendication 9, **caractérisé par le fait que** les optiques de mise en forme de faisceau (1) sont identiques.

Fig. 1

EP 1 601 072 B1

**Fig. 2**

EP 1 601 072 B1

Fig. 3

**Fig. 4**